(19) Europäisches Patentamt
European Patent Office
Office européen des brevets

(11) **EP 0 581 309 B1**

(12) **EUROPEAN PATENT SPECIFICATION**

(45) Date of publication and mention
of the grant of the patent:
**06.10.1999 Bulletin 1999/40**

(51) Int Cl.6: **G11C 29/00**

(21) Application number: **93112263.4**

(22) Date of filing: **30.07.1993**

(54) **Burn-in test enable circuit of a semiconductor memory device and burn-in test method**

Einbrennprüfeingabeschaltung eines Halbleiterspeichergeräts und Einbrennprüfverfahren dafür

Circuit d'autorisation de test de vieillissement d'un dispositif de mémoire à semi-conducteur et procédé de test de vieillissement associé

(84) Designated Contracting States:
**DE FR GB IT**

(30) Priority: **31.07.1992 KR 1381892**

(43) Date of publication of application:
**02.02.1994 Bulletin 1994/05**

(73) Proprietor: **SAMSUNG ELECTRONICS CO., LTD.**
**Suwon-city, Kyungki-do 441-373 (KR)**

(72) Inventor: **Choi, Yun-Ho**
**Suwon-city, Kyungki-do (KR)**

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 231 903**       **EP-A- 0 427 260**
**US-A- 5 025 422**

## Description

The present invention relates to a burn-in test of a semiconductor memory device according to the preamble part of claim 1 and a semiconductor memory for performing a burn-in test as set forth in the preamble part of claim 4.

The semiconductor memory device is liable to defects by problems in a process or any other reasons etc., and the generation ratio of the defects in a memory cell increases in proportion to the integrated degree of a semiconductor chip. As is well known, as the integration of the semiconductor chip increases, the size of each transistor contained within a single memory chip becomes smaller. Therefore, if an external power voltage of high voltage level is applied to the reduced transistor in size without any conversion, the stress such as the formation of strong electric field, etc. is increased, thereby causing the defects of the transistor. In order to ensure the reliability of the chip by initially detecting a defective memory cell, it is well known in the art to perform a burn-in test after the chip is fabricated. The burn-in test means that a high voltage over a specified external power voltage is applied to the gate of a memory cell transistor at a high temperature for a long time, in order to easily detect a defective chip after the fabrication of the chip is over. Then, since each element in the chip suffers from excessive stress, the defects is easily detected.

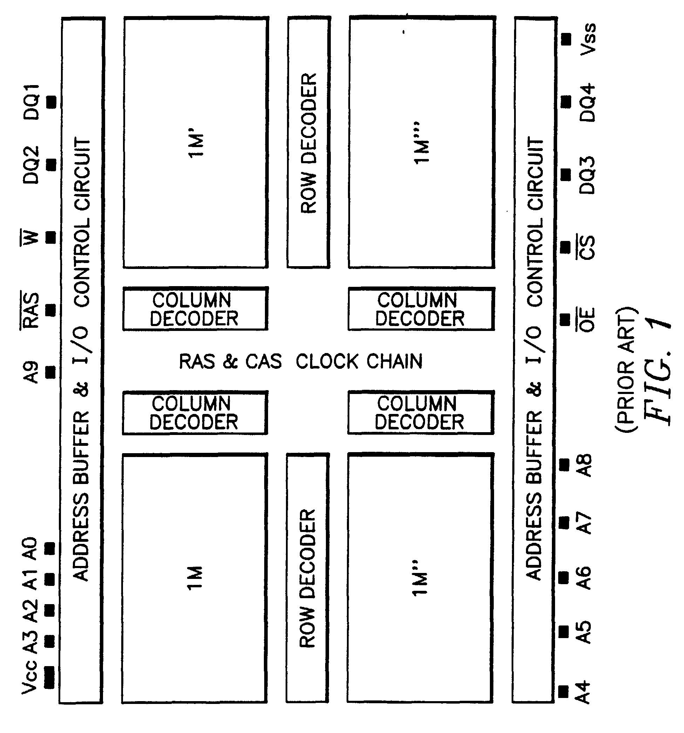

Now, such a burn-in test method typically used at the present time is described. In a dynamic RAM (Random Access Memory), for example, only a given word line is set to logic "high" during one row address strobe $\overline{RAS}$ cycle. That is, a plurality of rows are sequentially enabled to logic "high". Fig. 1 illustrates the chip architecture of a 4 Mega DRAM. In the case of the 4 Mega DRAM, a memory cell array is arranged in a matrix form of four subarrays each having 1024 rows. The 1024 rows of each subarray are sequentially enabled to logic "high" from a first row. Namely, if one row address strobe signal $\overline{RAS}$ is applied with an active signal, respective first rows of memory cell arrays 1M, 1M', 1M'' and 1M''' are set to logic "high", and if the row address strobe signal RAS is applied with a precharge signal, respective first rows of the memory cell arrays 1M, 1M', 1M'' and 1M''' are reset. Thereafter, if the row address strobe signal $\overline{RAS}$ is again applied with the active signal, respective second rows of the memory cell arrays 1M, 1M', 1M'' and 1M''' are set to logic "high", and by so doing, all the cell arrays are sequentially set to logic "high", to perform the burn-in test. If a burn-in time of 72 hours (a manufacturer of the chip may have the different burn-in time and the appropriate time may be selected according to the characteristics of the chip.) is selected, each access transistor suffers from the stress of the high voltage during about 4.2 minutes (72 hours ÷ 1024 = 4.2 minutes). However, as the number of memory cells constituting the chip is greatly incremented, the above-described burn-in test method results in the increment of the burn-in time. In a 16 Mega DRAM, for instance, in order to give the stress time of 4.2 minutes per access transistor, the burn-in time of 288 hours (72 x 4) is needed, and in the case of a 64 Mega DRAM, the burn-in time of 576 hours (72 x 8) is required. Consequently, it takes a long time to complete a single memory chip. Moreover, under such a technique, it is difficult to consider the reduction of the burn-in time for an effective burn-in test. Further, since one memory cell has the burn-in time of about 4.2 minutes, it is difficult to ensure the reliability for a complete burn-in test.

US-A-5,025,422 discloses a static RAM device with an internal activation signal generator and circuit means for overriding application of internal activation signals to the memory circuit under predetermined circumstances. In a test mode, the circuit means detects a higher voltage level of a predetermined external terminal of the device, resulting in that the internal activation signals are not used to limit the operating time of word lines and a sense amplifier. Thus, during the test mode, the word lines and the sense amplifier are activated for a longer period than during a normal read/write operation mode.

From EP-0 427 260 A2 a semiconductor non-volatile memory device having a test mode is known. During the test mode, a stress voltage can be applied simultaneously to all cells of the memory device. More specifically, a write stress test can be executed by selecting all bit lines and applying a high voltage thereto. The memory device includes a switch circuit which is turned on to supply a predetermined potential to the memory cells commonly during the normal operating mode. This switch circuit is turned off during the test mode to isolate the supply line from the memory cell.

The object of the present invention is to provide a semiconductor memory device and a burn-in method capable of efficiently performing a burn-in test within a short time.

This object is solved by a burn-in test method comprising the steps of claim 1 and by a semiconductor memory device having the features of claim 4.

The advantages and features of the present invention will become apparent from the following detailed description with reference to the attached drawings, in which:

Fig. 1 illustrates the typical chip architecture of a 4 Mega DRAM;
Fig. 2 is a circuit diagram of a burn-in enable circuit according to the present invention;
Fig. 3 illustrates a word line driver reset circuit; and
Fig. 4 is a circuit diagram of a word line driver.

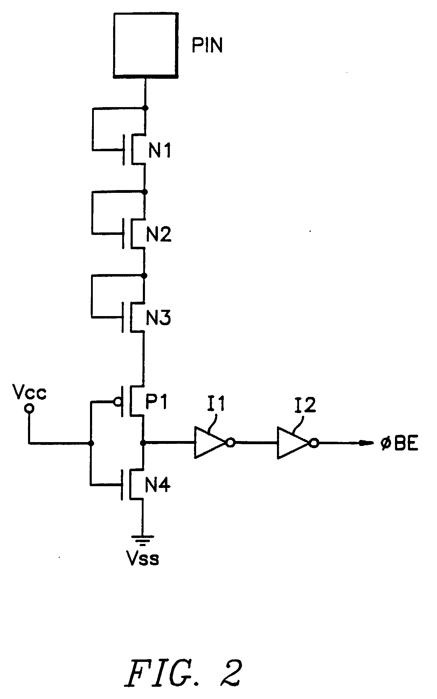

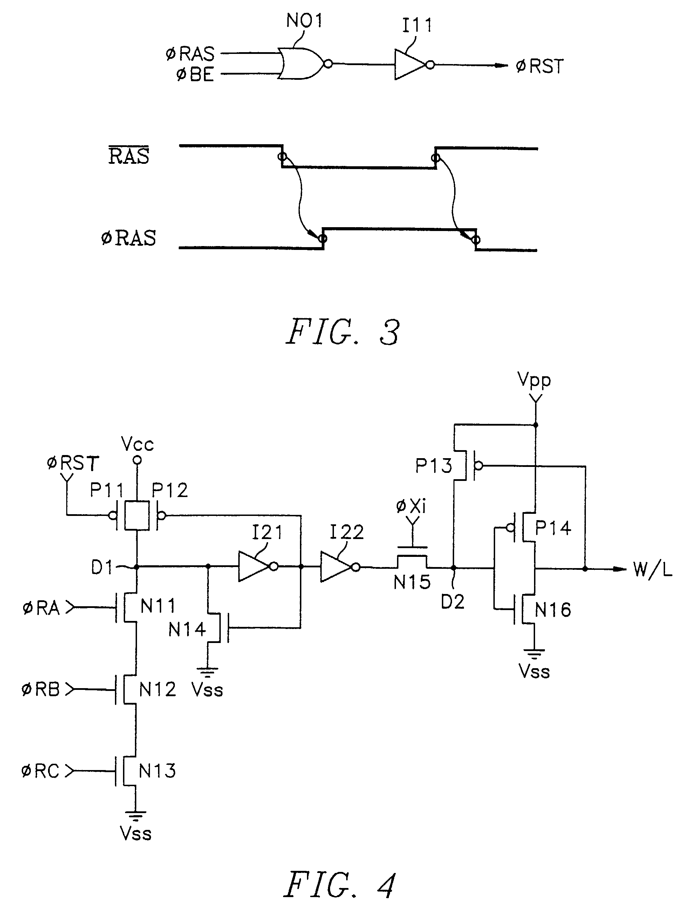

Referring to Fig. 2, the burn-in enable circuit embodying the present invention is shown. In Fig. 3, there is provided a word line driver reset circuit for selecting all the word lines in a single chip. Further, referring to Fig. 4, it will be readily appreciated that the output of the word line driver reset circuit of Fig. 3 selects all the word lines.

In a preferred embodiment of the invention, once a word line is enabled, the word line maintains the enabled state irrespective of other enabled word lines until a burn-in enable signal is disabled. However, in the conventional burn-in test method, if other word lines are enabled after one word line is enabled, the enabled word line is disabled.

Now, the burn-in test method according to the present invention is described. First, there is provided a burn-in voltage sensing circuit in the chip and this burn-in voltage sensing circuit is connected to any one pin among a plurality of pins of the chip. The burn-in voltage sensing circuit senses a burn-in test mode when a high voltage over an external power voltage is applied to the pin connected the burn-in sensing circuit. If the burn-in test mode is sensed, the burn-in voltage sensing circuit generates a burn-in enable signal when the high voltage is more than a specific voltage level. The burn-in enable signal is continuously generated while the high voltage is applied to the pin, and if the level of the high voltage applied to the pin is below the specific level, the burn-in enable signal is not generated. Meanwhile, during a burn-in operation, each word line is enabled according to a row address synchronized with the row address strobe signal $\overline{RAS}$ , and this operation is performed by a word line driver to which the row address is applied. In order to apply stress voltage to a first row in a memory cell array, if the row address synchronized with a first row address strobe signal $\overline{RAS}$ and designating the first row is applied, a first word line corresponding to the first row is enabled. After the first word line corresponding to the first row is enabled, in order to apply the stress voltage to a second row in the memory cell array, the row address strobe signal $\overline{RAS}$ is reset to a precharge signal, and again set to an active signal. However, in this case, even if the row address strobe signal $\overline{RAS}$ is precharged, the enable operation of the first word line is continuously maintained. This is because the burn-in enable signal controls a signal for resetting the word line driver so as to operate the word line driver continuously. Then the row address synchronized with a second row address strobe signal $\overline{RAS}$ and designating the second row is applied, and a second word line corresponding to the second row is enabled. At this time, the first and second word lines are simultaneously enabled. In order to apply the stress voltage to a third row in the memory cell array, the row address strobe signal $\overline{RAS}$ is reset to the precharge signal, and again set to the active signal. In the same manner, even if the row address strobe signal $\overline{RAS}$ is precharged, the enable operation of the first and second word lines is continuously maintained. The row address synchronized with a third row address strobe signal RAS and designating the third row is supplied and the word line corresponding to the third row is enabled. In this case, the first, second and third word lines are simultaneously enabled. Thus, the stress voltage is sequentially applied to all the word lines in the memory cell array, and once a word line is enabled, the word line maintains its state until the burn-in test is terminated. In the described burn-in test method, the burn-in time is considerably reduced and the stress voltage applied to one memory cell transistor is maintained for a long time, thereby remarkably improving the efficiency and reliability of the burn-in test.

In order to perform the burn-in test, a sensing operation for sensing a burn-in test mode of the chip by applying the high voltage to a specific pin (the pin to which an address is applied may be used ) of the chip is implemented by a burn-in enable circuit shown in Fig. 2. As shown, the burn-in enable circuit has a CMOS circuit P1 and N4 with the control terminal connected to a supply voltage terminal Vcc, a diode circuit N1, N2 and N3 serially connected between a specific pin of the chip and a pull-up terminal of the CMOS circuit P1 and N4, and a driver circuit I1 and I2 for driving the output of the CMOS circuit P1 and N4 and generating a burn-in enable signal $\phi BE$. During a normal operation, since a voltage level applied to the specific pin ranges from -1V to (Vcc + 1V), the logic state of the output of the driver circuit I1 and I2 is logic "low" and the burn-in enable signal $\phi BE$ does not occur. However, during the burn-in test, if a high voltage over "Vcc + 3Vtn + Vtp" (in this case, 3Vtn is the threshold voltage of the diode circuit N1, N2 and N3, and Vtp is the threshold voltage of a pull-up transistor P1) is applied to the specific pin, the pull-up transistor P1 of the CMOS circuit P1 and N4 is turned on and the burn-in enable signal $\phi BE$ of logic "high" is generated.

As shown in Fig. 3, a reset clock generating circuit for preventing all the word lines from resetting consists of a NOR gate NO1 with two inputs receiving a row address master clock signal $\phi RAS$ and the burn-in enable signal $\phi BE$, and an inverter I11 connected by its input to the output of the NOR gate NO1. At this time, the signal $\phi RAS$ is an internal signal converted by the row address strobe signal $\overline{RAS}$ as illustrated in timing charts. The output of the inverter I11 is a word line driver reset signal $\phi RST$ and the reset signal $\phi RST$ enables and disables the word line. If the burn-in enable signal $\phi BE$ of logic "low" is applied (that is, in the case that the burn-in mode is not enabled), the reset signal $\phi RST$ has the same phase with the row address master clock signal $\phi RAS$ and is to be of logic "low" during a precharge cycle of the row address strobe signal $\overline{RAS}$ , thereby resetting the word line driver. Meanwhile, if the burn-in enable signal $\phi BE$ of logic "high" is applied, the reset signal $\phi RST$ is maintained at logic "high" and the word line driver is not reset in the precharge cycle of the row address strobe signal $\overline{RAS}$.

Referring to Fig. 4 of the word line driver (the word line driver applied to the present invention may be easily performed with a word line driving circuit disclosed in Korea Patent Application No. 91-20828, filed Nov. 21, 1991, assigned to the same assignee as the present invention.), if the reset signal φRST of logic "high" is applied, a pull-up PMOS transistor P11 with the control input connected to the reset signal φRST is turned off, and then the logic state of a first node D1 becomes logic "low". As a result, the logic state of a second node D2 for driving the word line W/L becomes logic "low". Signals φRA, φRB and φRC are decoding signals of the row address and a signal φXi is a word line boosting signal. Therefore, while the reset signal φRST of logic "high" is supplied, the word line W/L is continuously enabled to logic "high". In this case, a voltage Vpp applied to the word line W/L is maintained at logic "high" by a charge pump circuit driven by a ring oscillator in the chip. That is, once a selected word line is enabled, the selected word line W/L is maintained at logic "high" until the logic state of the burn-in enable signal φBE becomes logic "low", and when the row address designating a last row in the memory cell array is applied, all the word lines of the chip are enabled to logic "high". The logic state of the word line W/L enabled to logic "high" becomes logic "low" when the generation of the burn-in enable signal φBE is over. The burn-in enable signal is not generated by cutting off the high voltage over "Vcc + 3Vtn + Vtp" applied to the specific pin of Fig. 2. As can be appreciated from the foregoing description, by simultaneously activating all the word lines in one memory cell array without resetting the word line after enabling the word line to logic "high", the burn-in time becomes equal to the stress time. Hence, the burn-in test is implemented within a short time, and simultaneously, the reliable burn-in test is ensured.

While a preferred embodiment of the present invention has been particularly shown and described, it will be understood by those skilled in the art that foregoing and other changes in form and details may be made. For example, in such circuits of Figs. 2 and 3, the number of diodes may be adjusted and the burn-in enable signal may be easily generated by using any one pin among address input pins of the chip.

As described above, since the word lines are simultaneously enabled to logic "high", the burn-in time is shortened and the burn-in test is particularly effective for a highly integrated semiconductor memory device of 16 Mega, 64 Mega, 256 Mega or more Mega bit-class.

## Claims

1. A burn-in test method of a semiconductor memory device comprising the steps of:

generating a burn-in enable signal (φBE) when a voltage larger than an external supply voltage is applied to a specific pin among a plurality of pins connected to the memory device;

enabling a first word line by inputting a row address synchronised with a first row address strobe signal (RAS);

enabling a second word line by inputting a row address synchronised with a second row address strobe signal, and

disabling said first and second word lines by an inverted burn-in enable signal when a voltage lower than the external supply voltage is applied to said specific pin

**characterized by**

continuously maintaining the enable operation of said first word line by said burn-in enable signal during enabling the second word line, *and sequentially applying a stress voltage to the enabled word lines in the memory device.*

2. The burn-in test method as claimed in claim 1, comprising the further step of sensing a burn-in test mode and generating the burn-in enable signal (φBE) when a voltage larger than an external supply voltage is applied to one of the pins to which an address is applied.

3. The burn-in test method according to claim 1 or 2 comprising the further step of enabling an N-th (N=3, 4,...) word line by inputting a row address synchronised with an N-th row address strobe signal while said first to N-1-th word lines are simultaneously enabled.

4. A semiconductor memory device comprising a memory cell array and a word line driver which receives a row address synchronised with a row address strobe signal (RAS) to enable a given word line of the memory array, comprising:

a burn-in enable circuit for generating a burn-in enable signal (φBE) when a voltage larger than an external supply voltage is applied to a specific pin of the memory device, and

a word line driver reset circuit (NO1, I11) for receiving a row address master clock (φRAS) converted to an internal signal by said row address strobe signal (RAS) and said burn-in enable signal (φBE), and disabling the given word line

**characterized in that**

said burn-in enable circuit being adapted to perform a burn-in test for all transistors in the memory cell array by *sequentially* enabling all word lines of the memory cell array *without disabling previously enabled word lines and apply-*

*ing a stress voltage to the enabled word lines.*

5. The semiconductor memory device as claimed in claim 4, wherein said burn-in enable circuit comprises:

> a CMOS circuit (P1,N4) having its control terminal connected to a supply voltage terminal;

> a driver circuit (l1,12) for driving the output of said CMOS circuit (P1,N4) and generating said burn-in enable signal ($\phi$BE).

6. The semiconductor memory device as claimed in claim 4 or 5, wherein said word line driver reset circuit comprises an OR circuit (NO1) with two inputs connected to said row address master clock ($\phi$RAS) and said burn-in enable signal ($\phi$BE).

**Patentansprüche**

1. Einbrenn-Testverfahren einer Halbleiterspeichervorrichtung, das die Schritte aufweist:

> Erzeugen eines Einbrenn-Freigabe-Signals ($\phi$BE), wenn eine Spannung größer als eine externe Versorgungsspannung an einem spezifischen Anschlußstift unter einer Vielzahl von Anschlußstiften, verbunden mit der Speichervorrichtung, angelegt wird;
> Freigeben einer ersten Wort-Leitung durch Eingeben einer Reihen-Adresse, die zu einem ersten Reihen-Adressen-Strobe-Signal (RAS) synchronisiert ist;
> Freigeben einer zweiten Wort-Leitung durch Eingeben einer Reihen-Adresse, die zu einem zweiten Reihen-Adressen-Strobe-Signal synchronisiert ist, und
> Sperren der ersten und der zweiten Wort-Leitung durch ein invertiertes Einbrenn-Freigabe-Signal, wenn eine Spannung niedriger als die externe Versorgungsspannung an den spezifischen Anschlußstift angelegt wird,

> gekennzeichnet durch

> kontinuierliches Beibehalten des Freigabe-Betriebs der ersten Wort-Leitung durch das Einbrenn-Freigabe-Signal während eines Freigebens der zweiten Wort-Leitung, und sequentielles Anlegen einer Beanspruchungs-Spannung an die freigegebenen Wort-Leitungen in der Speichervorrichtung.

2. Einbrenn-Testverfahren nach Anspruch 1, das den weiteren Schritt eines Feststellens eines Einbrenn-Test-Modus und eines Erzeugens des Einbrenn-

Freigabe-Signals ($\phi$BE) aufweist, wenn eine Spannung größer als eine externe Versorgungsspannung an einen der Anschlußstifte angelegt wird, an den eine Adresse angelegt wird.

3. Einbrenn-Testverfahren gemäß Anspruch 1 oder 2, das den weiteren Schritt eines Freigebens einer N-ten (N = 3, 4, ...) Wort-Leitung durch Eingeben einer Reihen-Adresse, die zu einem N-ten Reihen-Adressen-Strobe-Signal synchronisiert ist, während die erste bis N-1-te Wort-Leitungen simultan freigegeben werden, aufweist.

4. Halbleiterspeichervorrichtung, die ein Speicherzellenfeld und einen Wort-Leitungs-Treiber aufweist, der eine Reihen-Adresse aufnimmt, die zu einem Reihen-Adressen-Strobe-Signal (RAS) synchronisiert ist, um eine gegebene Wort-Leitung des Speicherfelds freizugeben, die aufweist:

> einen Einbrenn-Freigabe-Schaltkreis zum Erzeugen eines Einbrenn-Freigabe-Signals ($\phi$BE), wenn eine Spannung größer als eine externe Versorgungsspannung an einen spezifischen Stift der Speichervorrichtung angelegt wird, und
> einen Wort-Leitungs-Treiber-Rücksetz-Schaltkreis (NO1, l11) zum Aufnehmen eines Reihen-Adressen-Master-Takts ($\phi$RAS), der zu einem internen Signal durch das Reihen-Adressen-Strobe-Signal (RAS) und das Einbrenn-Freigabe-Signal ($\phi$BE) konvertiert ist, und Sperren der gegebenen Wort-Leitung,

> dadurch gekennzeichnet, daß

> der Einbrenn-Freigabe-Schaltkreis dazu angepaßt ist, um einen Einbrenn-Test für alle Transistoren in dem Speicherzellenfeld durch sequentielles Freigeben aller Wort-Leitungen des Speicherzellenfelds ohne Sperren zuvor freigegebener Wort-Leitungen und Anlegen einer Beanspruchungsspannung an die freigegebenen Wort-Leitungen durchzuführen.

5. Halbleiterspeichervorrichtung nach Anspruch 4, wobei der Einbrenn-Freigabe-Schaltkreis aufweist:

> einen CMOS-Schaltkreis (P1, N4), der seinen Steueranschluß mit einem Versorgungsspannungsanschluß verbunden besitzt;
> einen Treiber-Schaltkreis (11, 12) zum Ansteuern des Ausgangs des CMOS-Schaltkreises (P1, N4) und zum Erzeugen des Einbrenn-Freigabe-Signals ($\phi$BE).

6. Halbleiterspeichervorrichtung nach Anspruch 4 oder 5, wobei der Wort-Leitungs-Treiber-Rücksetz-Schaltkreis einen ODER-Schaltkreis (NO1) mit zwei Eingängen, verbunden mit dem Reihen-Adressen-Master-Takt ($\phi$RAS) und dem Einbrenn-Freigabe-Signal ($\phi$BE), aufweist.

## Revendications

1. Procédé de test de vieillissement d'un dispositif de mémoire à semi-conducteur comprenant les étapes consistant à :

produire un signal d'autorisation de vieillissement ($\phi$BE) lorsqu'une tension supérieure à une tension d'alimentation externe est appliquée à une broche spécifique parmi plusieurs broches connectées au dispositif de mémoire ; valider une première ligne de mots en entrant une adresse de ligne synchronisée avec un premier signal d'impulsion de sélection de ligne (RAS) ; valider une seconde ligne de mots en entrant une adresse de ligne synchronisée avec un second signal d'impulsion de sélection de ligne ; et invalider lesdites première et seconde lignes de mots par un signal d'autorisation de vieillissement inversé lorsqu'une tension inférieure à la tension d'alimentation externe est appliquée à ladite broche spécifique

caractérisé par l'étape consistant à

continuer sans interruption l'opération de validation de ladite première ligne de mots par ledit signal d'autorisation de vieillissement durant la validation de la seconde ligne de mots et à appliquer de façon séquentielle une tension de contrainte aux lignes de mots validées dans le dispositif de mémoire.

2. Procédé de test de vieillissement selon la revendication 1, comprenant une autre étape consistant à détecter un mode de test de vieillissement et à produire le signal d'autorisation de vieillissement ($\phi$BE) lorsqu'une tension supérieure à une tension d'alimentation externe est appliquée à une des broches à laquelle une adresse est appliquée.

3. Procédé de test de vieillissement selon la revendication 1 ou 2 comprenant une autre étape consistant à valider une N-ième (N = 3, 4, ...) ligne de mots en entrant une adresse de ligne synchronisée avec un N-ième signal d'impulsion de sélection de ligne tandis que lesdites première à N-1-ième lignes de mots sont validées de façon simultanée.

4. Dispositif de mémoire à semi-conducteur comprenant une matrice de cellules de mémoire et un gestionnaire de ligne de mots qui reçoit une adresse de ligne synchronisée avec un signal d'impulsion de sélection de ligne (RAS) pour valider une ligne de mots donnée de la matrice mémoire, comprenant :

un circuit d'autorisation de vieillissement pour produire un signal d'autorisation de vieillissement ($\phi$BE) lorsqu'une tension supérieure à une tension d'alimentation externe est appliquée à une broche spécifique du dispositif de mémoire, et un circuit de remise à zéro de gestionnaire de ligne de mots (NO1, I11) pour recevoir une horloge centrale d'adresse de ligne ($\phi$RAS) convertie en un signal interne par ledit signal d'impulsion de sélection de ligne (RAS) et par ledit signal d'autorisation de vieillissement ($\phi$BE), et à invalider la ligne de mots donnée

caractérisé en ce que

ledit circuit d'autorisation de vieillissement est conçu pour exécuter un test de vieillissement pour tous les transistors dans la matrice de cellules de mémoire en validant de façon séquentielle toutes les lignes de mots de la matrice de cellules de mémoire sans invalider des lignes de mots précédemment validées et en appliquant une tension de contrainte aux lignes de mots validées.

5. Dispositif de mémoire à semi-conducteur selon la revendication 4, dans lequel ledit circuit d'autorisation de vieillissement comprend :

un circuit CMOS (P1, N4) ayant sa borne de commande connectée à une borne de tension d'alimentation ; un circuit d'attaque (I1, I2) pour attaquer la sortie dudit circuit CMOS (P1, N4) et pour produire ledit signal d'autorisation de vieillissement ($\phi$BE).

6. Dispositif de mémoire à semi-conducteur selon la revendication 4 ou 5, dans lequel ledit circuit de remise à zéro de gestionnaire de ligne de mots comprend un circuit OU (NO1) avec deux entrées connectées à ladite horloge centrale d'adresse de ligne ($\phi$RAS) et audit signal d'autorisation de vieillissement ($\phi$BE).

(PRIOR ART)

*FIG. 1*

EP 0 581 309 B1

*FIG. 2*

*FIG. 3*

*FIG. 4*